Europäisches Patentamt

European Patent Office

Office européen des brevets

(11) Publication number: **0 115 158**
**B1**

## EUROPEAN PATENT SPECIFICATION

(45) Date of publication of patent specification: **14.09.88**

(51) Int. Cl.⁴: **H 05 K 3/02, H 01 L 23/14**

(21) Application number: **83307762.1**

(22) Date of filing: **20.12.83**

(54) Substrate for semiconductor module.

(30) Priority: **23.12.82 JP 230399/82**

(43) Date of publication of application:
**08.08.84 Bulletin 84/32**

(45) Publication of the grant of the patent:
**14.09.88 Bulletin 88/37**

(84) Designated Contracting States:
**DE FR GB NL**

(56) References cited:
**DE-A-3 036 128**
**US-A-3 994 430**
**US-A-4 328 048**

**B.B.C. NACHRICHTEN, vol. 64, no. 7, 1982,
pages 196-200, Mannheim, DE., A. NEIDIG:
"Neue Leistungs-Halbleiter-Module mit hoher
Lastwechselfestigkeit"
Photoresist, W.S. DeForest, McGraw-Hill Book
Comp., 1975, pp. 11-17**

(73) Proprietor: **KABUSHIKI KAISHA TOSHIBA
72, Horikawa-cho Saiwai-ku
Kawasaki-shi Kanagawa-ken 210 (JP)**

(72) Inventor: **Mizunoya, Nobuyuki c/o Patent
Division
Tokyo Shibaura Denki K.K. 72, Horikawa-cho
Saiwai-ku Kawasaki-shi Kanagawa-ken (JP)**
Inventor: **Kohama, Hajime c/o Patent Division
Tokyo Shibaura Denki K.K. 72, Horikawa-cho
Saiwai-ku Kawasaki-shi Kanagawa-ken (JP)**
Inventor: **Sugiura, Yasuyuki c/o Patent Division
Tokyo Shibaura Denki K.K. 72, Horikawa-cho
Saiwai-ku Kawasaki-shi Kanagawa-ken (JP)**

(74) Representative: **Kirk, Geoffrey Thomas et al
BATCHELLOR, KIRK & EYLES 2 Pear Tree Court
Farringdon Road
London EC1R 0DS (GB)**

EP 0 115 158 B1

Courier Press, Leamington Spa, England.

## Description

The present invention relates to a method of manufacturing a substrate for receiving a semiconductor module.

A substrate for a semiconductor module generally includes a metal sheet, such as copper sheet, cladded on to a ceramic plate. It is known to metallise a surface of the ceramic plate by coating it with molybdenum paste and to then attach to it a preformed copper sheet or molybdenum sheet, of prescribed shape, by brazing the preformed metal sheet to the ceramic.

There is a problem with substrates formed in this manner. The thermal expansion coefficients of the metal sheet and the ceramic plate are different. When electronic components, such as silicon pellets, are mounted on the substrate, the ceramic plate and metal sheet are heated and there is a tendency for the substrate to crack and split.

In addition to this functional problem of cracking and splitting during circuit component mounting, it is somewhat difficult and expensive to manufacture the substrate. The process of bonding via metallising is a complicated process. This general type of manufacture is disclosed in U.S. Patent No. 3994430 — Cusano et al. A substrate for a semiconductor module, produced according to the known process described above, is shown in Figure 9 of Cusano '430.

An alternative to the method taught in Cusano '430 includes the steps of stamping a copper sheet to a prescribed pattern, putting the patterned copper sheet into contact with the ceramic plate and placing it in a furnace to bond the copper sheet and the ceramic plate directly by heating. With a substrate produced by such a method, since the thermal expansion coefficient of the metal sheet is close to that of the ceramic plate, the problem of splitting is minimised when components, such as silicon pellets, are mounted directly on to the copper sheet. However, with this alternative method, there is the disadvantage of poor precision because prestamping copper plate to a complex shape is quite difficult.

It is also known from B. B. C. Nachrichten, Vol. 64 (1982) No. 7, pages 196 to 200, for a substrate to be formed by disposing a sheet of copper on the surface of a ceramic plate and heating them to a temperature in the range 1065° to 1082°. After a short time there is formed between the copper and the ceramic a thin eutectic layer of melt which, after cooling down, bonds the copper firmly to the ceramic plate. The sheet of copper may be preformed prior to the heating stage or it may be etched subsequent to the heating stage.

According to the present invention the process known from B. B. C. Nachrichten disclosed above is characterised in that, the ceramic is a substantially non-oxide ceramic and, prior to heating of the ceramic plate in contact with the copper sheet, the ceramic plate is subjected to a process to form an oxide surface coating thereon.

When using aluminium nitride as the ceramic plate, substrates with superior heat dissipation can be obtained. For the copper sheet used in this invention, it is advantageous to use, for example, tough pitch electrolytic copper containing 100—2000 ppm oxygen. Where necessary, the copper sheet can be given an oxidation treatment before use.

When using this type of copper sheet which contains oxygen, the heating atmosphere should be a non-oxidising atmosphere; when using copper sheet which does not contain, oxygen, heating should be carried out in an oxidising atmosphere.

The etching process is possible because only etchable copper is on the ceramic plate. There is no non-etchable molybdenum paste or brazing paste disposed between the copper and the ceramic, as in some prior art arrangements.

In order that the invention may be more readily understood, it will now be described, by way of example only, with reference to the accompanying drawings, in which:

Figure 1A—1I illustrate the process steps associated with the manufacture of a substrate;

Figures 2A—2C illustrate some of the process steps associated with a second process; and

Figures 3A—3C illustrate some of the process steps associated with an embodiment of the present invention.

A copper sheet is laid in contact with the surface of a ceramic plate. The combination is heated to a temperature below the melting point of the copper (1082°C) and above the copper/copper oxide eutectic temperature (1065°C).

It is preferable to use a tough pitch electrolytic copper or copper that has been given an oxidation treatment by a known method before use.

The ceramic plate is a non-oxide type ceramic, such as a nitride, e.g. silicon nitride, aluminium nitride, titanium nitride or silicon aluminium oxynitride; a carbide, e.g. silicon carbide or titanium carbide; or a boride, e.g. lanthanum boride, to which an auxiliary material has been added to aid sintering. For example, when the sintering auxiliary is oxygen, it may be contained in the form of an oxide, such as yttrium oxide, titanium oxide, alumina, silica, magnesium oxide, or a glass.

For non-oxide ceramics, it is necessary to use them after carrying out a surface treatment, such as an oxidation treatment by a bonding agent.

The bonding agent which is used produces a eutectic in combination with copper and may include oxygen, sulphur or the like. The addition of a bonding agent to the surface layer of the ceramic plate may be performed by a conventional method. For example, when a ceramic plate consists of a nitride and the bonding agent is oxygen, the ceramic plate is heated to 1250—1500°C in air or a gas mixture ($H_2 + N_2 + H_2O$), referred to as a wet forming gas, to achieve oxidation.

It is advantageous if a copper sheet is bonded to both of the opposite surfaces of the ceramic plate, because the copper sheet on the reverse surface of the plate contributes to heat dissipation. One may also bond ceramic plate and copper sheet which are rather larger than the required shape for subsequent cutting to the required size. Further, by using a copper sheet in the form of a long tape wound into a roll, and continuously feeding two copper sheets from such rolls to sandwich the ceramic plate between these copper sheets and applying heat in this state, the rate of production can be increased. After bonding copper sheets to ceramic plate in this way, acid washing is carried out to remove the oxide film from the surface of the copper sheets.

The required pattern of copper on the ceramic is then formed by screen printing, or the photoresist method, and the etching process is carried out with copper chloride solution. By removing the resist, washing and then drying, the substrate for a semiconductor module is obtained.

Substrates for semiconductor modules obtained in this way are supplied for use in mounting silicon chips, etc., on to the copper sheet.

### Example 1

28 mm × 58 mm × 0.3 copper sheets 1, 3 of tough pitch electrolytic copper were laid in contact with opposite surfaces of a 30 mm × 60 mm × 0.7 mm alumina ceramic plate 5 and bonded to it by insertion for 30 minutes in a furnace at 1075°C. The substrate so formed was then washed with hydrochloric acid and resist screen-printing was carried out on one side of the sheets. Etching by spraying for 15—20 minutes with ferric chloride etching fluid and spraying with sodium hydroxide to peel off the resist was followed by washing and drying. If necessary, a de-greasing process step can be employed in which the vapour of trichloroethylene is used to remove oil from the surface of the copper sheet. This can be done before or after washing with hydrochloric acid. Also, after each process step, there may be a washing step with water.

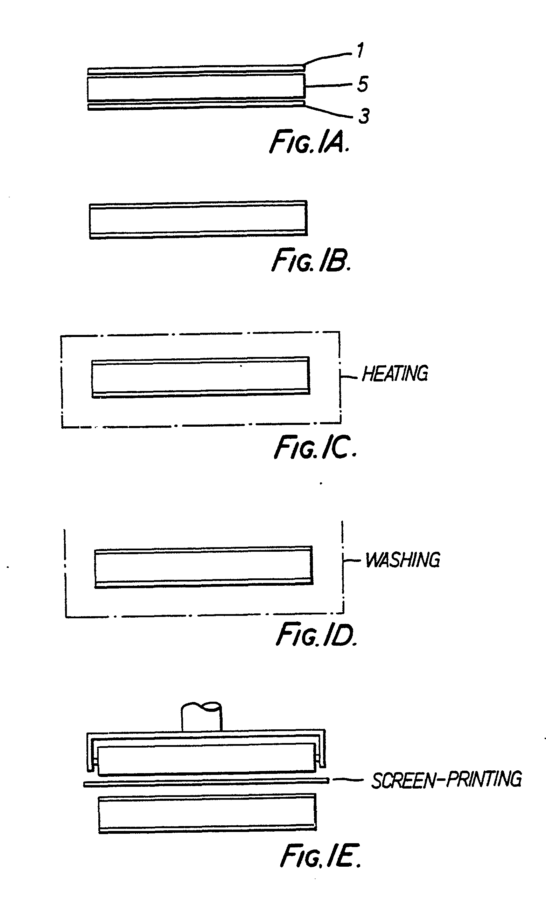

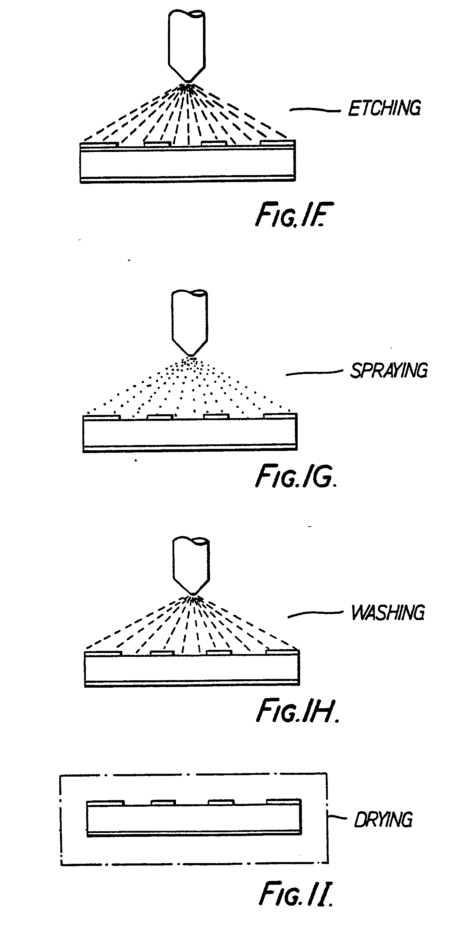

The method steps of this example of the prior art are illustrated in Figures 1A—1I.

### Example 2

28 mm × 58 mm × 0.3 mm copper sheets 11, 13 were given an oxidation treatment and then laid in contact with opposite surfaces of a 30 mm × 60 mm × 0.7 mm alumina ceramic plate 15. The same method as Example 1 was then carried out.

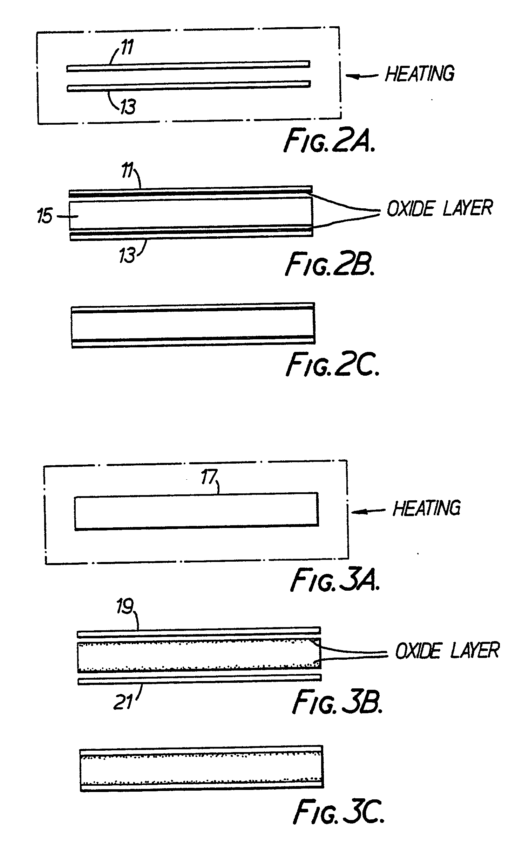

The method steps of this example of the prior art are illustrated in Figurs 2A—2C.

In both examples, where the ceramic is a non-oxide ceramic, or one which is mainly non-oxide, it is subjected to a pre-treatment process to form an oxide coating thereon. This is described in Example 3.

### Example 3

A ceramic plate 17 was used which consisted of silicone nitride containing 4% by weight of yttrium oxide and 4% by weight of alumina as a sintering auxiliary and which had dimensions of 30 mm × 30 mm × 2 mm. The ceramic plate was heated at 1250°C in air for 1 hour and the surface of the ceramic plate was slightly whitened with oxide. Copper sheets 19, 22 of tough pitch electrolytic copper (300 to 500 ppm oxygen content) and having dimensions of 10 mm × 50 mm × 0.3 mm were laid in contact with the opposite surfaces of the ceramic plate. The plate and sheets were then heated at 1075°C in this state in a nitrogen atmosphere after which the members were cooled to substantially ambient temperature. The method of Example 1 was then continued.

The method steps of this example of the invention are illustrated in Figures 3A—3C.

When semiconductor modules, such as silicon pellets, are mounted by soldering on a substrate manufactured in this manner, problems, such as cracking, do not arise. It is, moreover, possible to form conductor patterns of complex form with precision.

### Claims

1. A method of manufacturing a substrate for receiving a semiconductor module in which a sheet of copper is disposed on a surface of a ceramic plate; the plate and the sheet are heated to a temperature in the range 1065—1083°C at which temperature a thin eutectic layer of melt is formed; the plate and sheet are allowed to cool to cause the melt to bond the sheet to the substrate and, thereafter, the copper sheet is shaped by etching; characterised in that the ceramic is a substantially non-oxide ceramic and, prior to heating of the ceramic plate in contact with the copper sheet, the ceramic plate is subjected to a process to form an oxide surface coating thereon.

2. A method as claimed in claim 1, in which the copper sheet is oxidised prior to being disposed on the ceramic plate.

3. A method as claimed in any preceding claim, in which an additional sheet of copper is disposed on the opposite surface of the ceramic plate and the plate and both sheets are heated to bond the plate to both sheets of copper.

4. A method as claimed in any preceding claim, wherein the or each copper sheet is of tough pitch electrolytic copper.

### Patentansprüche

1. Verfahren zur Herstellung einer Trägerschicht zur aufnahme eines Halbleitermodule, bei dem ein Kupferblättchen auf einer Oberfläche einer Keramikplatte angeordnet wird, die Keramikplatte und das Kupferblättchen auf eine Temperatur von 1065 bis 1083°C, bei der eine eutektische Schmelzschicht entsteht, erwärmt wird, die Keramikplatte und das Kupferblättchen anschließend abgerkühlt werden, so daß das Kupferblättchen mit der Trägerschicht durch die erstarrende Schmelze verbunden werden und bei dem anschließend das Kupferblättchen durch einen Ätzvorgang seine gewünschte Form erhält, dadurch gekennzeichnet, daß für die Keramikplatte im wesentlichen ein nichtoxidisches Kereamikmaterial verwendet wird und daß vor dem Erwärmen der mit dem Kupferblättchen in Berührungskontakt stehenden Keramikplatt diese einen Prozeß durchläuft, in dem auf die Keramikplatte eine Oxid-Oberflächenbeschichtung aufgebracht wird.

2. Verfahren nach Anspruch 1, dadurch gekennzeichnet, daß das Kupferblättchen noch vor dem Aufbringen auf die Keramikplatte oxidiert wird.

3. Verfahren nach mindestens einem der Anspruch 1 bis 2, dadurch gekennzeichnet, daß ein weiteres Kupferblättchen auf der gegenüberliegenden Oberfläche der Keramikplatte angeordnet wird und daß zur Verbindung der Keramikplatte mit den beiden Kupferblättchen die Keramikplatte und die beiden Kupferblättchen erwärmt werden.

4. Verfahren nach mindestens einem der Ansprüche 1 bis 3, dadurch gekennzeichnet, daß das bzw. jedes Kupferblättchen aus Elektrolyt-Zähkupfer besteht.

## Revendications

1. Procédé pour fabriquer un substrat destiné à recevoir un module semi-conducteur qui consiste à disposer une feuille de cuivre sur l'une des surfaces d'une plaque de céramique; à chauffer la plaque et la feuille à une température de l'ordre de 1065 à 1083°C, température à laquelle une mince couche eutectique en fusion se forme; à laisser refroidir la plaque et la feuille afin que la matière en fusion puisse lier la feuille en substrat, après quoi on donne à la feuille de cuivre la forme voulue par décapage, caractérisé en ce que la céramique est une céramique pratiquement non-oxyde et en ce que, avant de chauffer la plaque de céramique au contact de la feuille de cuivre, ou soumet ladite plaque de céramique à un traitement destiné à former un revêtement d'oxyde à sa surface.

2. Procédé selon la revendication 1, caractérisé en ce qu'on oxyde la feuille de cuivre avant de la disposer sur la plaque de céramique.

3. Procédé selon l'une quelconque des revendications précédentes, caractérisé en ce qu'on dispose une seconde feuille de cuivre sur la surface opposée de la plaque de céramique et en ce qu'on chauffe la plaque et les deux feuilles de cuivre afin d'unir ladite plaque à ces deux feuilles de cuivre.

4. Procédé selon l'une quelconque des revendications précédentes, caractérisé en ce que le cuivre constituant la ou chacune des feuilles de cuivre est un cuivre électrolytique à forte pente.

1
5
3

*Fig. IA.*

*Fig. IB.*

HEATING

*Fig. IC.*

WASHING

*Fig. ID.*

SCREEN-PRINTING

*Fig. IE.*

ETCHING

*FIG.IF.*

SPRAYING

*FIG.IG.*

WASHING

*FIG.IH.*

DRYING

*FIG.II.*

FIG.2A.

FIG.2B.

FIG.2C.

FIG.3A.

FIG.3B.

FIG.3C.